# FASCICULE DE BREVET EUROPEEN

(11) **EP 1 145 300 B1**
(45) Date de publication et mention de la délivrance du brevet: **09.12.2009**
(21) Numéro de dépôt: 00900566.1
(22) Date de dépôt: 13.01.2000
(51) Int. Cl.: H01L 21/336, H01L 21/28, H01L 29/10, H01L 29/423

(54) **PROCEDE DE FABRICATION D'UN TRANSISTOR MIS SUR UN SUBSTRAT SEMI-CONDUCTEUR**
VERFAHREN ZUR HERSTELLUNG EINES MIS-TRANSISTORS AUF EINEM HALBLEITERSUBSTRAT
METHOD OF MANUFACTURING A MIS TRANSISTOR ON A SEMICONDUCTOR SUBSTRATE

(30) Priorité: 15.01.1999 FR 9900389
(43) Date de publication de la demande: 17.10.2001
(73) Titulaire: COMMISSARIAT A L'ENERGIE ATOMIQUE, 75015 Paris (FR)
(72) Inventeur: DELEONIBUS, Simon, 38640 Claix (FR); GUEGAN, Georges, 38180 Seyssins (FR); CAILLAT, Christian, 38120 Saint Egrève (FR); COUDERT, Fabien, 38400 Saint Martin d'Hères (FR)
(74) Mandataire: Weber, Etienne Nicolas
(86) Numéro de dépôt international: PCT/FR2000/000058
(87) Numéro de publication internationale: WO 2000/042647

(56) Documents cités:
- EP-A- 0 768 715
- DE-A- 4 208 537
- FR-A- 2 757 312
- US-A- 5 576 227
- US-A- 5 668 021
- US-A- 5 750 430
- US-A- 5 773 348

## Description

### Domaine technique

La présente invention se rapporte à un procédé de fabrication d'un transistor MIS à grille auto-alignée . On entend par transistor MIS un transistor ayant une structure de type Métal-Isolant-Semiconducteur telle que, par exemple, celle des transistors MOS (Métal-Oxyde-Semiconducteur).

L'invention concerne plus particulièrement la fabrication, sur un substrat de silicium, de tels transistors, aptes à fonctionner dans le domaine des hyperfréquences.

L'invention trouve des applications en microélectronique pour la fabrication de circuits hyperfréquence et/ou de puissance, par exemple pour la réalisation de circuits utilisables dans le domaine des télécommunications.

### État de la technique antérieure

De façon connue, les composants et circuits de type hyperfréquence sont habituellement réalisés sur des substrats en arséniure de gallium (AsGa) ou sur des substrats de silicium (Si).

Pour raisons de coût, les circuits réalisés sur substrat d'arséniure de gallium ne sont généralement pas d'une grande complexité et ne présentent pas une densité d'intégration élevée. L'architecture de ces circuits n'est de ce fait pas optimisée du point de vue de leur compacité.

Le document (1) dont les références sont précisées à la fin de la présente description, concerne un procédé de fabrication d'un transistor MIS à grille auto-alignée sur ses régions de source et de drain.

Ce procédé fait appel à une étape de mise en place d'une grille factice sacrificielle pour la définition des emplacements d'une région de source et, d'une région de drain, et de l'emplacement d'une grille dite définitive. La mise en oeuvre d'une grille factice permet d'affranchir la grille définitive des traitements thermiques liés à la formation des régions de source et de drain.

En outre, le procédé du document (1) autorise la fabrication d'un transistor compact, en réduisant notamment la garde des contacts par rapport aux interconnexions réalisées au niveau grille.

Dans une recherche constante de l'augmentation de la densité d'intégration des composants et des circuits, un objectif est de réduire la taille individuelle des transistors et plus particulièrement la taille de leur grille.

Lorsque la taille de la grille est réduite, se posent des problèmes d'ajustage de la tension de seuil des transistors et des problèmes de perçage entre drain et source.

Une augmentation de la densité de dopage de la région de canal située sous la grille, permet d'ajuster la tension de seuil et d'augmenter l'immunité au perçage entre les zones de source et de drain.

Cependant, l'augmentation de la densité de dopage sous la grille s'accompagne d'une augmentation des capacités parasites existant entre d'une part la source et le canal, et d'autre part, entre le drain et le canal ; et la mobilité des porteurs de charges s'en trouve réduite.

Lorsqu'on diminue la dimension de la grille, le dopage augmente dans le canal et il devient plus difficile d'optimiser les performances en fréquence des composants. Une des limitations de performance en fréquence est la capacité parasite source-canal ou drain-canal.

Une description de l'état de la technique est également donnée par les documents (3) et (4) dont les références sont précisées à la fin de la description.

### Exposé de l'invention

Un but de la présente invention est de proposer un transistor MIS et son procédé de fabrication ne présentant pas les limitations évoquées ci-dessus.

Un but est en particulier de proposer un tel transistor qui puisse être réalisé avec des dimensions particulièrement réduites tout en présentant une bonne immunité au perçage.

Un but est aussi de pouvoir ajuster la tension de seuil Vs du transistor à une valeur souhaitée, choisie en fonction de la tension d'alimentation.

Enfin, un but est de proposer un transistor avec de faibles capacités parasites et susceptible de fonctionner à des fréquences élevées.

Pour atteindre ces buts, l'invention a plus précisément pour objet un procédé de fabrication sur un substrat semi-conducteur d'un transistor MIS. Le procédé comprend les étapes successives suivantes :
a) formation sur le substrat d'une couche, dite couche piédestal, et sur cette couche, formation d'une grille factice sacrificielle, la grille factice étant disposée au-dessus d'une région du substrat dite région de canal,
b) formation dans le substrat de régions de source et de drain, auto-alignées sur la grille factice et délimitant au moins en partie la région de canal,
c₁) enrobage latéral de la grille factice avec au moins un matériau isolant électrique et élimination de la grille factice pour obtenir un puits au-dessus de la région de canal
c₂) formation d'espaceurs sur des flancs du puits,
c₃) dopage d'une partie de la région de canal par implantation ionique dans le puits en utilisant les espaceurs comme masque d'implantation,
d) formation dans le puits d'une grille, dite grille définitive, séparée du substrat par une couche d'isolant de grille.

Conformément à l'invention, la formation de la grille définitive est précédée par l'élimination d'au moins une partie de la couche piédestal située au fond du puits et d'au moins une partie de la couche piédestal s'étendant sous les espaceurs des flancs du puits pour former dans cette couche au moins un évidement surplombant une partie des régions de source et de drain, la grille définitive s'étendant dans ledit évidement.

Grâce aux espaceurs qui équipent les flancs du puits, et qui sont utilisés comme masque d'implantation le dopage du canal se limite à une partie centrale du canal sans atteindre les régions de source et de drain.

Cette caractéristique permet d'ajuster, en contrôlant la densité du dopage, la tension de seuil du transistor. Elle permet aussi d'augmenter l'immunité du transistor à un perçage drain-source, et surtout de réduire les capacités parasites entre le canal et les régions de source et de drain.

Il convient de préciser que l'étape de dopage c₃ n'exclut pas l'utilisation d'un substrat qui est initialement dopé. Dans ce cas, l'opération de dopage conduit simplement à l'augmentation de la concentration ou à la modification du type ou du profil de dopage dans la partie centrale du canal.

Par ailleurs, grâce à l'élimination partielle de la couche de piédestal sous les espaceurs, la grille vient s'étendre en partie au-dessus des régions de source et de drain. Lorsque les source et drain sont dopés de façon graduelle, c'est-à-dire respectivement avec une zone faiblement dopée tournée vers le canal et une zone plus fortement dopée tournée à l'opposé du canal, les bords de la grille s'étendent jusqu'au-dessus des zones faiblement dopées. Une telle architecture permet de réaliser un bon compromis entre la réduction de la résistance d'accès au canal et la réduction des capacités parasites source-canal et drain-canal.

L'extension du chevauchement de la grille avec les zones faiblement dopées peut être comprise, par exemple, entre 0 (lorsque le bord de la grille arrive à la limite d'une zone faiblement dopée) et la moitié de la largeur des zones faiblement dopées.

Selon un aspect particulier avantageux de l'invention, le procédé peut comporter en outre, avant l'achèvement de l'étape de dopage c₃, la formation d'une couche d'oxyde sur les espaceurs. Lorsque ces espaceurs formés sur les flancs du puits sont réalisés en un matériau pouvant être oxydé, la couche d'oxyde est formée de préférence par oxydation des espaceurs.

La couche d'oxyde a pour but non seulement d'augmenter l'épaisseur des espaceurs sur les flancs mais surtout de contrôler avec précision cette épaisseur de façon à définir une zone dopée très mince au centre du canal.

En effet, la distance libre entre les surfaces des espaceurs en regard conditionne l'extension de la zone de dopage dans le canal.

En contrôlant ainsi l'extension de cette zone, par l'oxydation des espaceurs, il est possible d'ajuster avec précision la tension de seuil Vs du transistor.

La tension Vs est choisie telle que Vs<Va/3 par exemple, où Va est la tension d'alimentation du transistor.

Selon un autre aspect particulier, on peut former la grille factice sur une couche, dite couche piédestal, recouvrant la surface du substrat. On élimine alors au moins une partie de la couche piédestal située au fond du puits, avant la formation de ladite grille définitive.

Lors de l'élimination totale ou partielle de la couche de piédestal dans le puits, les espaceurs latéraux formés sur les flancs du puits ont également pour fonction de protéger ces flancs et d'éviter ainsi un élargissement du puits ; ce qui serait préjudiciable à l'augmentation de la compacité du transistor.

Comme indiqué précédemment, l'élimination de la couche de piédestal au fond du puits peut avantageusement comporter l'élimination d'au moins une partie de la couche piédestal s'étendant sous les espaceurs des flancs du puits pour former au moins un évidement surplombant une partie des régions de source et de drain. La grille définitive qui est finalement formée s'étend alors dans cet évidement.

Par ailleurs, le procédé de l'invention peut comporter, avant la formation de la grille définitive, l'élimination de la couche piédestal au fond du puits et la mise en place d'une couche d'isolant de grille.

Dans la mesure où l'oxyde de grille mis en place au fond du puits présente une épaisseur plus faible que celle de l'oxyde de la couche piédestal, on obtient in fine, une grille présentant en coupe une forme de T renversé.

On peut observer que lorsque les espaceurs des flancs latéraux du puits sont oxydés, leur couche superficielle d'oxyde est également éliminée ou entamée lors de l'élimination (désoxydation) de la couche piédestal au fond du puits.

Ainsi, après cette étape, et avant la mise en place de la grille définitive, on peut former une nouvelle couche d'oxyde sur les espaceurs. Cette mesure permet d'ajuster ou d'exagérer la forme en T renversé de la grille.

L'invention permet d'obtenir un transistor MIS comprenant dans un substrat une région de canal, des régions de source et de drain disposées de part et d'autre du canal, et une grille disposée sensiblement au-dessus de la région de canal , le canal présentant une partie centrale dopée entre les régions de source et de drain, et séparée desdites régions de source et de drain.

Dès lors que le canal peut être globalement dopé ou au contraire non intentionnellement dopé, on entend par partie centrale dopée une partie présentant un dopage de concentration supérieure à la concentration de dopage moyenne du canal.

Le dopage peut ainsi être ajusté, sous la grille.

En outre, cette partie centrale est considérée comme séparée des régions de source et de drain dans le sens qu'une zone moins dopée ou non intentionnellement dopée est respectivement située entre la partie centrale (dopée) et chacune des régions de sources et de drain.

Selon un autre aspect, la grille peut présenter en coupe une forme de T (renversé) avec une partie formant la barre horizontale du T tournée vers le canal et s'étendant partiellement au-dessus des régions de source et de drain.

D'autres caractéristiques et avantages de la présente invention ressortiront mieux de la description qui va suivre, en référence aux figures des dessins annexés. Cette description est donnée à titre purement illustratif et non limitatif.

### Brève description des figures

- La figure 1 est une coupe schématique d'un substrat destiné à la formation d'un transistor MIS et illustre une première étape de fabrication d'une grille factice sacrificielle.
- La figure 2 illustre une étape d'implantation de régions de source et de drain dans le substrat de la figure 1.
- La figure 3 illustre une étape complémentaire d'implantation des régions de source et de drain.
- La figure 4 est une coupe schématique de la structure après enrobage puis élimination de la grille factice.
- La figure 5 montre en coupe la structure de la figure 4 préparée pour l'implantation d'une zone dopée entre les régions de source et de drain.
- La figure 6 montre en coupe, et à titre de variante, une autre possibilité de préparation de la structure pour l'implantation de la zone dopée.
- Les figures 7 et 8 montrent en coupe des étapes de préparation de la structure de la figure 6 pour la mise en place d'une grille définitive.
- La figure 9 montre, en coupe, la mise en place de la grille définitive.
- Les figures 10 et 11 montrent en coupe une variante de réalisation de la structure correspondant à la figure 4.

### Description détaillée de modes de mise en oeuvre de l'invention

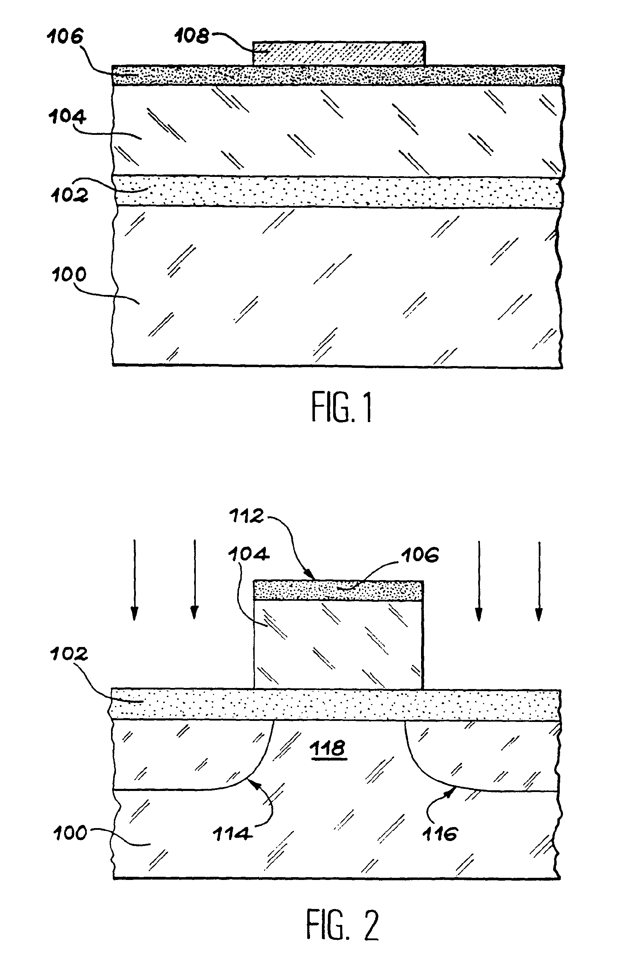

La figure 1 montre un substrat de silicium 100 dont la surface a été oxydée afin de former une couche 102 d'oxyde de silicium dite couche piédestal.

La couche piédestal 102 est recouverte d'une couche de silicium polycristallin ou amorphe 104 et d'une couche de nitrure de silicium 106, dans lesquelles doit être formée ultérieurement une grille factice. L'épaisseur de l'ensemble des couches de silicium 104 et de nitrure de silicium 106 est par exemple de l'ordre de 100 à 500 nm.

La référence 108 désigne un masque de gravure, tel que par exemple un masque de résine photosensible, qui est formé à la surface de la couche de nitrure de silicium 106.

Le masque de gravure 108 permet de fixer les dimensions et l'emplacement de la grille factice.

La grille factice 112 visible sur la figure 2, est formée par gravure sélective anisotrope des couches de nitrure de silicium 106 et de silicium 104, selon le motif défini par le masque 108, avec arrêt sur la couche piédestal 102. Le masque de gravure 108 est ensuite éliminé.

La formation de la grille factice est suivie d'une première implantation d'ions à faible dose. Selon que le transistor que l'on souhaite réaliser est du type PMOS ou NMOS, les ions sont choisis de façon à réaliser des zones d'un type de conductivité p ou n. a titre d'exemple, lors de la première implantation, on implante des ions de bore avec une dose de 10¹³ à 10¹⁴ cm⁻² à une énergie de 3 à 25keV pour les PMOS. Dans le cas d'un transistor NMOS, on utilise du phosphore ou de l'arsenic dans la même gamme de dose et d'énergie.

Les régions implantées, repérées par les références 114 et 116 constituent respectivement des régions de drain et de source du transistor. La portion de substrat s'étendant entre les régions de source et de drain, et située sensiblement sous la grille factice, constitue la canal 118 du transistor.

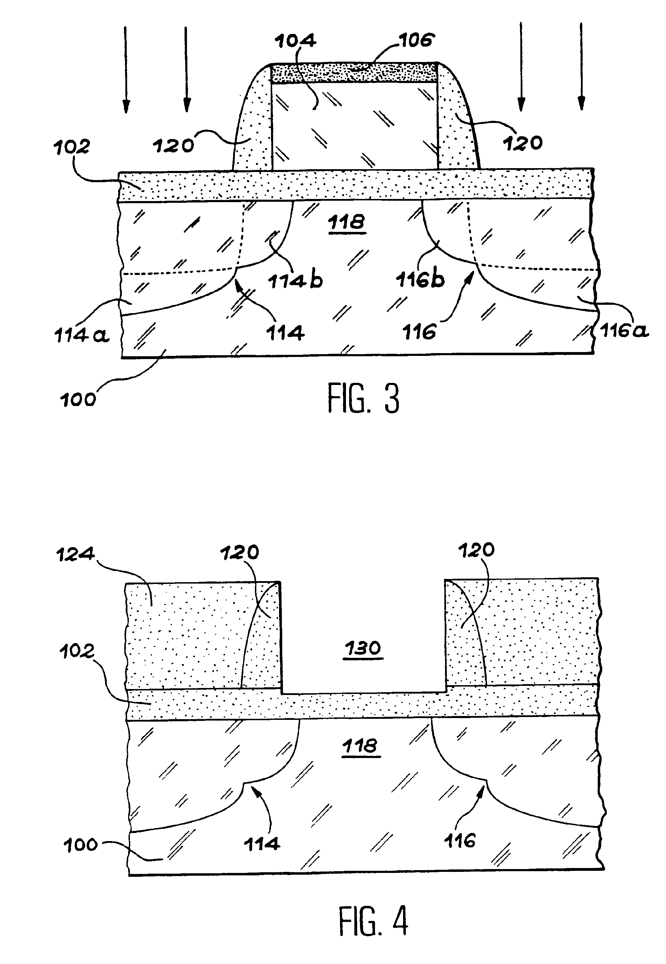

Dans une réalisation particulière du transistor, la formation des régions de drain et de source peut, comme le montre la figure 3, être complétée par une deuxième implantation, à plus forte dose, d'ions du même type de conductivité que ceux de la première implantation.

Préalablement à cette deuxième implantation, la grille factice 112 est équipée d'espaceurs latéraux 120.

Ces espaceurs sont formés par un dépôt conforme d'une couche d'oxyde de silicium puis par gravure anisotrope de cette couche de façon à préserver les espaceurs latéraux sur les flancs de la grille factice.

Les zones de source et de drain obtenus au terme de la deuxième implantation présentent des premières parties 114a, 116a de plus forte concentration et des deuxièmes parties 114b, 116b, sous la forme d'extensions dépassant des premières parties en direction du canal, et présentant une plus faible concentration d'impuretés dopantes.

La figure 4 montre la formation d'une couche d'enrobage 124 de la grille factice.

La couche d'enrobage 124 peut être formée par un dépôt d'une ou de plusieurs couches de matériau choisis, par exemple, parmi l'oxyde de silicium dopé, l'oxyde de silicium non intentionnellement dopé et le verre borophosphosilicate (BPSG).

La couche d'enrobage est ensuite aplanie et polie (planarisée) avec arrêt sur la couche de nitrure de silicium de la grille factice (non visible sur la figure 4).

Après la planarisation, la grille factice est éliminée de sorte que seuls demeurent à la surface de la couche piédestal les espaceurs latéraux 120 et la couche d'enrobage 124. Dans la suite du texte, les espaceurs latéraux 120 susmentionnés sont désignés par espaceurs "extérieurs".

L'élimination de la grille factice permet de former un puits 130 dont le fond est constitué par la couche piédestal 102 et dont les parois ou flancs sont formés par les espaceurs "extérieurs" 120.

Une description plus détaillée des étapes de procédé permettant d'aboutir à une structure conforme à la figure 4, de même que des variantes de réalisation possibles peuvent être trouvées dans le document (1) déjà mentionné.

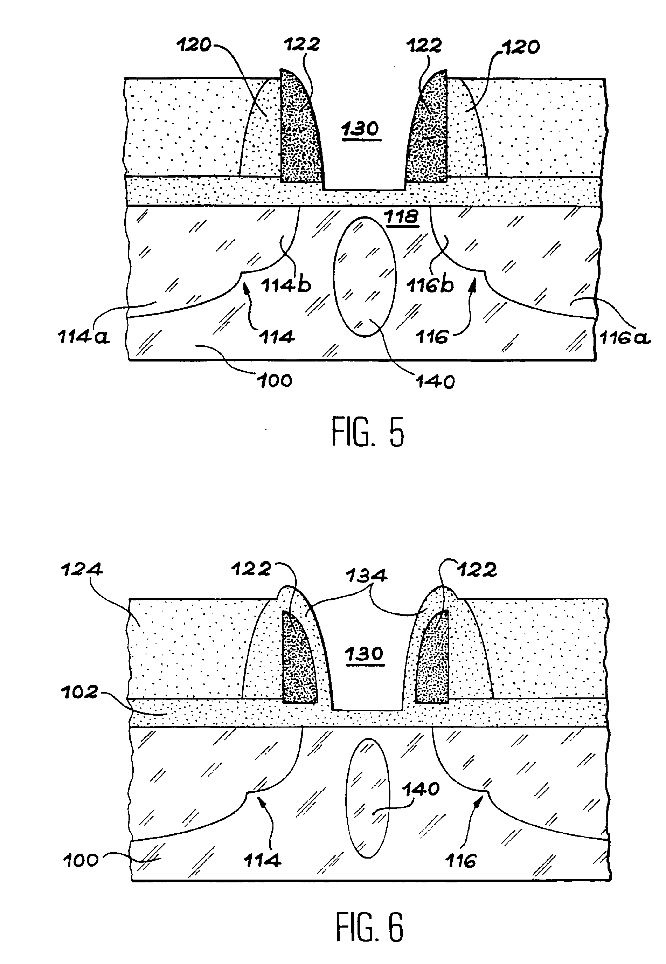

Le procédé est poursuivi, comme le montre la figure 5, par la formation sur les flancs du puits 130 d'espaceurs latéraux 122 en nitrure de silicium.

Les espaceurs latéraux 122, dits espaceurs "intérieurs" sont formés par le dépôt d'une couche de nitrure de silicium qui recouvre l'ensemble de la structure, puis par gravure ionique réactive, isotrope et sélective de la couche de façon à ne préserver de cette couche qu'une partie recouvrant les flancs (verticaux). A titre de variante, les espaceurs peuvent aussi être réalisés en silicium amorphe ou polycristallin.

On observe que la couche piédestal 102, de même que la couche d'enrobage 124 sont légèrement entamées lors de cette gravure en raison d'une sélectivité de gravure de nitrure par rapport à l'oxyde qui n'est pas parfaite.

La formation des espaceurs latéraux intérieurs est suivie d'une ou plusieurs implantation(s) ionique(s) permettant d'ajuster la tension de seuil des transistors en utilisant la couche d'enrobage 124 et les espaceurs latéraux 122 comme masque d'implantation. Les ions implantés peuvent être des ions de bore ou d'indium pour un dopage de type P ou des ions phosphore ou d'arsenic pour un dopage de type N. Eventuellement, l'implantation peut être suivie d'un recuit. Un recuit peut aussi être effectué à l'occasion d'une étape d'oxydation (de grille) ultérieure du procédé. L'implantation a lieu à travers la couche piédestal.

Grâce aux espaceurs latéraux intérieurs, il est possible de former dans la région de canal une zone dopée 140 située sensiblement à mi-distance entre les régions de source et de drain et dont l'extension latérale n'atteint pas lesdites régions de source et de drain.

Comme évoqué précédemment, on entend par zone dopée 140 une zone qui présente par rapport au reste du canal une plus forte concentration de dopage.

Les conditions d'implantation, c'est-à-dire notamment la dose et l'énergie, sont de préférence ajustées sur un profil souhaité de la zone dopée s'étendant, par exemple, de la surface vers le volume du substrat 100 avec un pic de concentration situé au centre du canal 118 à une profondeur correspondant à la moitié desdites deuxièmes parties 114b, 116b des régions de source et de drain.

A titre d'exemple, l'implantation est réalisée avec une dose de bore de 1 à 5.10¹³ et une énergie de 10 KeV pour une profondeur de jonction des deuxièmes parties 114b et 116b de l'ordre de 25 nm.

Grâce à l'implantation, on obtient pour le transistor une bonne tenue au perçage, en volume et en surface.

La fabrication du transistor peut être achevée par l'élimination de la couche piédestal 102 au fond du puits, puis par la mise en place d'une couche d'oxyde de grille et d'une grille.

Ces opérations sont décrite plus en détail avec les figures qui suivent et qui illustrent un perfectionnement avantageux de l'invention.

Selon un aspect de ce perfectionnement, on effectue, avant l'implantation, une oxydation superficielle du nitrure de silicium des espaceurs de façon à transformer une couche superficielle du nitrure de silicium en une couche d'oxyde de silicium. Cette couche d'oxyde est repérée avec la référence 134 sur la figure 5.

L'oxydation a une fonction double. Elle permet, d'une part, de transformer une partie du nitrure des espaceurs en oxyde de façon à pouvoir graver ultérieurement cette partie, en même temps que l'oxyde de la couche piédestal. L'oxydation provoque d'autre part un gonflement des espaceurs (la densité de l'oxyde est inférieure à celle du nitrure). Ce gonflement est mis à profit pour réduire et ajuster finement l'espace restant entre les espaceurs.

L'ajustage de cet espace permet, au moment de l'implantation, de contrôler l'extension de la zone dopée.

La couche d'oxyde 134 est réalisée de préférence par voie d'oxydation froide ou par voie humide sulfo-oxygénée. Pour la mise en oeuvre de l'oxydation froide, on peut se reporter, par exemple, au document (2) dont la référence est précisée à la fin de la description. Ces procédés d'oxydation permettent de travailler à des températures relativement faibles et donc d'éviter toute diffusion involontaire des zones de source et de drain.

Selon une variante, la couche d'oxyde peut également être formée par dépôt, c'est-à-dire par apport de matière.

Après la formation de la couche d'oxyde 134 sur les espaceurs, on procède à l'implantation de la zone dopée 140 de la façon décrite précédemment, en utilisant les espaceurs équipés de la couche d'oxyde comme masque d'implantation.

On observe sur la figure 6, comparativement à la figure 5, que l'extension latérale de la zone dopée 140 est plus faible.

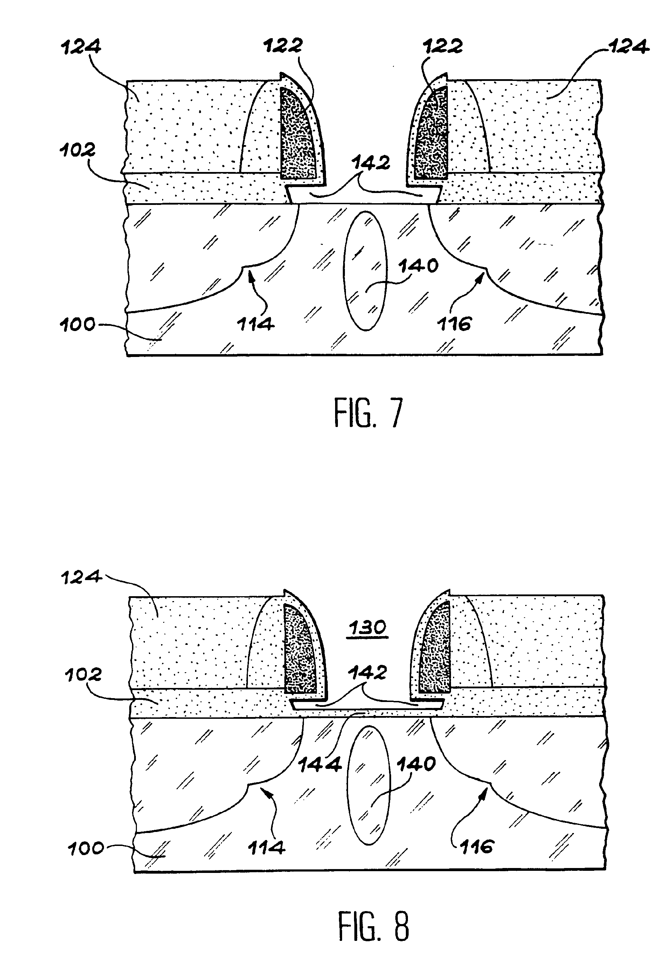

La figure 7 montre une étape de désoxydation lors de laquelle on élimine la couche piédestal 102 au fond du puits 130. La désoxydation peut avoir lieu dans une solution de FH dilué dans l'eau ou de FH tamponné (NH₄F) .

Lors de cette étape on élimine également une partie de la couche piédestal située sous les espaceurs, pour former une cavité, ou évidement, 142 s'étendant jusqu'au-dessus des zones de source et de drain 114, 116.

On observe qu'une partie au moins de la couche d'oxyde 134 qui recouvre les espaceurs est également éliminée lors de la désoxydation. Cette caractéristique est particulièrement avantageuse dans la mesure où elle favorise la formation de la cavité 142.

La figure 8 montre la formation d'une couche isolante de grille 144 qui recouvre le fond du puits 130 et qui s'étend dans la cavité 142.

La couche d'isolant de grille est par exemple une couche d'oxyde formée par oxydation ou par un procédé de dépôt chimique en phase vapeur (CVD). Ce procédé (CVD) permet accessoirement de restaurer une partie de la couche d'oxyde 134 en formant une nouvelle couche d'oxyde sur les espaceurs intérieurs.

Selon une variante, on peut envisager de n'éliminer qu'une partie de l'épaisseur de la couche de piédestal au fond du puits pour éviter la formation de la couche d'isolant de grille. Cette solution est cependant moins avantageuse car elle ne permet pas de contrôler finement l'épaisseur de la couche d'oxyde restante, et ne favorise pas la réalisation de la cavité 142.

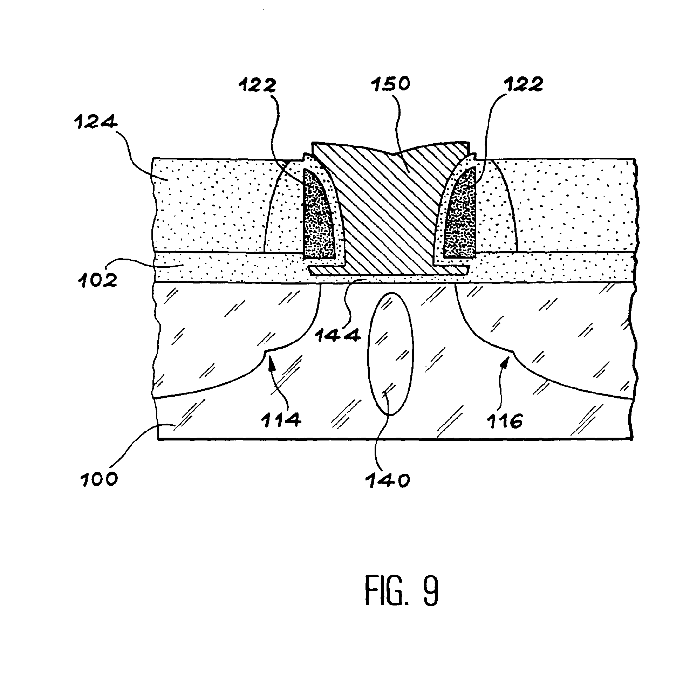

La figure 9 montre une étape lors de laquelle une grille définitive 150 est mise en place dans le puits 130.

Le matériau de grille est choisi en fonction notamment de la tension de seuil souhaitée pour le transistor, mais aussi pour ses propriétés de conduction. Le matériau de la grille assure en effet la conduction électrique entre la base de la grille en contact avec l'isolant de grille et la partie supérieure susceptible d'être mise en contact avec une ligne d'interconnexion non représentée.

Le matériau de grille est par exemple un métal tel que TiN, W, Ta, ou du silicium polycristallin, déposé par exemple par CVD.

Le matériau de grille s'étend dans la cavité 142 de sorte que la grille présente en coupe une forme de T renversé.

La partie supérieure de la grille, en raison de la forme caractéristique des espaceurs latéraux qui s'effilent en s'éloignant du substrat, présente également une forme évasée qui, en coupe, évoque un T.

Cette forme facilite la prise de connexion ultérieure sur la grille pour interconnecter le transistor avec d'autres composants. De plus, à la surface du transistor, c'est-à-dire au-dessus de la couche d'enrobage 124, le matériau de grille peut être mis en forme par polissage ou par gravure selon un motif souhaité. Le matériau de grille peut aussi être aplani par polissage jusque sur la couche d'enrobage 124.

La fabrication du transistor peut être achevée par la réalisation de prises de contact sur les régions de source et de drain, à travers la couche d'enrobage et à travers la couche piédestal. Ces dernières opérations sont bien connues en soi et ne sont pas décrites davantage ici.

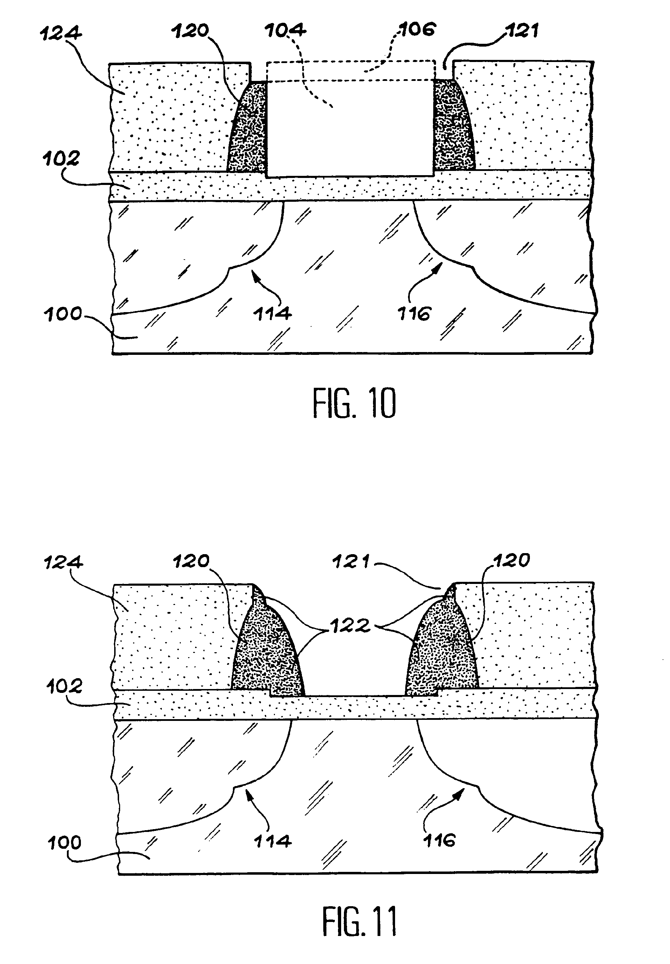

A titre complémentaire, les figures 11 et 12 montrent une variante de l'étape du procédé, correspondant à la réalisation des espaceurs latéraux.

Dans cette variante, les espaceurs extérieurs 120 et intérieurs 122 sont tous réalisés en nitrure de silicium.

La figure 10 montre la structure telle qu'obtenue après élimination de la grille factice. A titre indicatif, les emplacements de la couche 104 de silicium et de la couche de nitrure de silicium 106 sont représentées en trait discontinu.

On observe au sommet des espaceurs extérieurs 120 un décrochement 121 de la couche d'enrobage 124.

Ce décrochement provient des effets combinés d'une gravure parasite de la couche d'enrobage lors de l'élimination (par gravure) de la grille factice et d'une gravure de la partie supérieure des espaceurs extérieurs (en nitrure) 120 lors de l'élimination de la couche de nitrure de silicium 106 de la couche factice. En effet, lors de l'élimination de cette couche, toutes les parties exposées en nitrure subissent une gravure.

La figure 11 montre la formation des espaceurs latéraux intérieurs 122.

Ceux-ci viennent s'adosser contre les espaceurs extérieurs 120 et contre le bord de la couche d'enrobage 124, à la hauteur du décrochement 121.

Les opérations subséquentes restent identiques à celles déjà décrites. Cette réalisation particulière permet d'accentuer la forme en T de la partie de la grille définitive qui sera formée finalement dans le puits.

Ainsi, en considérant également les étapes suivantes déjà décrites, la grille présente finalement en coupe une forme en double T (T et T renversé) encore appelé forme en I.

### DOCUMENTS CITES

***(1)*** FR-A-2 757 312
***(2)*** "Sealing Silicon Nitride Removal in SILO Field Isolation for Submicron Technologies" de S. Deleonibus et coll. J. Electrochem. Soc., vol. 138, n°12, Décembre 1991, p. 3739-3742
***(3)*** US-A-5 750 430
***(4)*** US-A-5 576 227

## Revendications

1. Procédé de fabrication sur un substrat semi-conducteur (100) d'un transistor MIS comprenant les étapes successives suivantes :
a) formation sur le substrat d'une couche (102), dite couche piédestal, et sur cette couche, formation d'une grille factice (112) sacrificielle, la grille factice étant disposée au-dessus d'une région du substrat dite région de canal (118),
b) formation dans le substrat de régions de source et de drain (114, 116), auto-alignées sur la grille factice et délimitant au moins en partie la région de canal,
c₁) enrobage latéral de la grille factice avec au moins un matériau isolant électrique et élimination de la grille factice pour obtenir un puits (130) au-dessus de la région de canal
c₂) formation d'espaceurs (122) sur des flancs du puits,
c₃) dopage d'une partie (140) de la région de canal par implantation ionique dans le puits en utilisant les espaceurs comme masque d'implantation,
d) formation dans le puits d'une grille (150), dite grille définitive, séparée du substrat par une couche d'isolant de grille,
et dans lequel la formation de la grille définitive est précédée par l'élimination d'au moins une partie de la couche piédestal située au fond du puits et d'au moins une partie de la couche piédestal (102) s'étendant sous les espaceurs des flancs du puits pour former dans cette couche au moins un évidement (142) surplombant une partie des régions de source et de drain, la grille définitive s'étendant dans ledit évidement.

2. Procédé selon la revendication 1, dans lequel l'étape b) de formation des régions de drain et de source comporte successivement :
- une première implantation ionique de dopage en utilisant la grille factice (112) comme masque d'implantation,
- la formation d'espaceurs latéraux (120) sur les flancs de la grille factice,
- une deuxième implantation ionique de dopage en utilisant la grille factice équipée d'espaceurs comme masque d'implantation.

3. Procédé selon la revendication 1, dans lequel, avant l'achèvement de l'étape de dopage c₃, on forme une couche d'oxyde (134) sur les espaceurs des flancs du puits.

4. Procédé selon la revendication 3, dans lequel on forme la couche d'oxyde (134) par oxydation à froid des espaceurs des flancs du puits.

5. Procédé selon la revendication 2, dans lequel on forme les espaceurs latéraux (120) sur la grille factice et les espaceurs (122) sur les flancs du puits en un même matériau.

6. Procédé selon la revendication 1, comprenant avant la formation de la grille définitive, l'élimination de la couche piédestal au fond du puits et la mise en place d'une couche (144) d'isolant de grille.

7. Procédé selon la revendication 1, dans lequel après l'élimination de ladite partie de la couche piédestal et avant la mise en place de la grille définitive on forme une nouvelle couche d'oxyde sur les espaceurs des flancs du puits.

## Claims

1. A method for manufacturing an MIS transistor on a semiconductor substrate comprising the following successive stages:
a) formation on the substrate of a layer (102), called the pedestal layer and, on this layer, formation of sacrificial dummy gate (112), the dummy gate being set above a region of the substrate called the channel region (118).
b) formation in the substrate of source and drain regions (114, 116), self-aligned on the dummy gate and defining at least in part the channel region.
c₁) lateral coating of the dummy gate with at least one electrical insulation substance and elimination of the dummy gate to obtain a well (130) above the channel region,
c₂) formation of spacers (122) on the sides of the well,
c₃) doping of a part (140) of the channel region by ionic implantation in the well, using the spacers as implantation mask.
d) formation of a gate (150) in the well, called the definitive gate, separated from the substrate by a gate insulator layer,
and in which the formation of the definitive gate is preceded by the elimination of at least a part of the pedestal layer located at the bottom of the well and at least a part of the pedestal layer (102) extending under the spacers of the sides of the well, in order to form in this layer at least one recess (142) above a part of the source and drain regions, the definitive gate extending into said recess.

2. A method according to claim 1, in which stage b) for forming the source and drain regions comprises successively:
- a first ionic doping implantation using the dummy gate (112) as implantation mask,
- the formation of lateral spacers (120) on the flanks of the dummy gate,
- a second ionic doping implantation using the dummy gate equipped with spacers as implantation mask.

3. A method according to claim 1, in which before terminating the doping stage c₃, one forms a layer of oxide (134) on the spacers of the sides of the well.

4. A method according to claim 3, in which one forms the oxide layer (134) by cold oxidation of the spacers of the sides of the well.

5. A method according to claim 2, in which one forms the lateral spacers (120) on the dummy gate and the spacers (122) on the sides of the well in a same substance.

6. A method according to claim 1, comprising before the formation of the definitive gate, the elimination of the pedestal layer at the bottom of the well and the formation of a gate insulator layer (144).

7. A method according to claim 1, in which after elimination of said part of the pedestal layer and before setting the definitive gate in place, a new oxide layer is formed on the spacers of the sides of the well.

## Patentansprüche

1. Verfahren zur Herstellung eines MIS-Transistors auf einem Halbleitersubstrat (100), das die folgenden Schritte umfasst:
a) Bildung einer Sockelschicht genannten Schicht (102) auf dem Substrat und auf dieser Schicht ein Opfer-Attrappengate (112), wobei das Attrappengate über einem Kanalbereich genannten Bereich (118) des Substrats angeordnet ist,
b) Bildung - in dem Substrat - von Source- und Drain-Bereichen (114, 116) mit Selbstausrichtung auf das Attrappengate und zumindest partieller Begrenzung des Kanalbereichs,
c₁) Seitliche Umhüllung des Attrappengates mit wenigstens einem elektrisch isolierenden Material und Eliminierung des Attrappengates, so dass man über dem Kanalbereich einen Schacht (130) erhält.
c₂) Bildung von Spacern (122) an den Flanken des Schachts,
c₃) Dotierung eines Teils (140) des Kanalbereichs durch Ionenimplantation in dem Schacht, indem man die Spacer als Implantationsmaske benutzt,
d) Bildung - in dem Schacht - eines Gates (150), definitives Gate genannt, vom Substrat getrennt durch eine Gate-Isolationsschicht,
und bei dem der Bildung des definitiven Gates die Eliminierung wenigstens eines Teils der an Boden des Schachts befindlichen Sockelschicht und wenigstens eines Teils der sich unter den Spacern der Schachtflanken erstreckenden Sockelschicht vorausgeht, um in dieser Schicht wenigstens eine Aussparung (142) herzustellen, die über einen Teil der Bereiche von Source und Drain ragt, wobei sich das definitive Gate in die genannte Aussparung hinein erstreckt.

2. Verfahren nach Anspruch 1, bei dem der Schritt b) zur Bildung der Drain- und Source-Bereiche nacheinander umfasst:
- eine erste Dotierungsionenimplantation, wobei das Attrappengate (112) als Implantationsmaske benutzt wird,
- die Bildung von lateralen Spacern (120) auf den Flanken des Attrappengates,
- eine zweite Dotierungsionenimplantation, wobei das mit Spacern versehene Attrappengate als Implantationsmaske benutzt wird.

3. Verfahren nach Anspruch 1, bei dem man vor Abschluss des Dotierschritts c₃ auf den Spacern der Schachtflanken eine Oxidschicht (134) bildet.

4. Verfahren nach Anspruch 3, bei dem man die Oxidschicht (134) durch Kaltoxidation der Spacer der Schachtflanken bildet.

5. Verfahren nach Anspruch 2, bei dem man die lateralen Spacer (120) auf dem Attrappengate und die Spacer (122) auf den Flanken des Schachts aus demselben Material bildet.

6. Verfahren nach Anspruch 1, bei dem man vor der Bildung des definitiven Gates die Sockelschicht am Boden des Schachts eliminiert und durch eine Gateisolationsschicht (144) ersetzt.

7. Verfahren nach Anspruch 1, bei dem man nach der Elimination des genannten Teils der Sockelschicht und vor der Bildung des definitiven Gates auf den Spacern der Flanken des Schachts eine neue Oxidschicht bildet.
